## Europäisches Patentamt
## European Patent Office
## Office européen des brevets

(19)

(11) Veröffentlichungsnummer: **0 053 669**
**B1**

(12) **EUROPÄISCHE PATENTSCHRIFT**

(45) Veröffentlichungstag der Patentschrift:
06.02.85

(21) Anmeldenummer: 81108069.6

(22) Anmeldetag: 08.10.81

(51) Int. Cl.⁴: **C 08 F 238/02**, C 08 F 226/00,
C 08 G 61/02, H 01 B 1/12,
C 09 K 3/16

(54) Verfahren zur Herstellung von elektrisch leitfähigen Copolymeren und deren Verwendung in der Elektrotechnik und zur antistatischen Ausrüstung von Kunststoffen.

(30) Priorität: 24.11.80 DE 3044111

(43) Veröffentlichungstag der Anmeldung:
16.06.82 Patentblatt 82/24

(45) Bekanntmachung des Hinweises auf die Patenterteilung:
06.02.85 Patentblatt 85/6

(84) Benannte Vertragsstaaten:
BE DE FR GB

(56) Entgegenhaltungen:
POLYMER COMMUNICATIONS, Band 20, Dezember
1979, Seiten 1441-1443 GARY E. WNEK: "Electrically
Conducting Derivative of Poly(p-phenylene vinylene)"
BER. BUNSENGES. PHYS. CHEM., Band 83, 1979 Seiten
427-432 H. NAARMANN: "Elektrisch leitfähige
Polyaromaten"

(73) Patentinhaber: **BASF Aktiengesellschaft,**
**Carl-Bosch-Strasse 38, D-6700 Ludwigshafen (DE)**

(72) Erfinder: **Naarmann, Herbert, Dr., Haardtblick 15,**
**D-6719 Wattenheim (DE)**
Erfinder: **Penzien, Klaus, Dr., Bensheimer Ring 18,**
**D-6710 Frankenthal (DE)**
Erfinder: **Naegele, Dieter, Dr., Obere Jakobstrasse 8,**
**D-6520 Worms (DE)**
Erfinder: **Schlag, Johannes, Dr., Leuschnerstrasse 36,**
**D-6700 Ludwigshafen (DE)**

## Beschreibung

Die Erfindung betrifft ein Verfahren zur Herstellung von elektrisch leitfähigen Copolymeren durch Copolymerisation von Acenaphthylen, Biphenyl, Terphenyl, Quarterphenyl oder von Oligophenylen oder N-Vinylcarbazol, 2- oder 4-Vinylpyridin oder von N,N-Divinylanilin und Acetylen bei Temperaturen von − 80 bis + 100 °C.

Bei derartigen Polymerisationsverfahren sind Katalysatoren in Mengen von 0,001 bis 50 Gew.-%, bezogen auf das Gewicht der zur polymerisierenden Monomeren, erforderlich, um eine Polymerisation in Gang zu bringen.

Es ist bereits bekannt, Vinylverbindungen mit Hilfe kationisch wirkender Katalysatoren zu polymerisieren (vgl. W.R. Soerenson u. T.W. Campbell, «Preparative Methods of Polymer Chemistry», Interscience Publ., New York 1968, Seite 265).

Es ist auch bereits bekannt, elektrisch leitfähige Polymere durch oxidative Kupplung von aromatischen Verbindungen mit Hilfe von Lewis-Säuren herzustellen (vgl. «Naturwissenschaften, 56, [1969], Seite 308). Dieses Verfahren wurde jedoch nur bei aromatischen und cycloaliphatischen Systemen durchgeführt. Die erhaltenen Polymeren waren relativ niedermolekular mit Polymerisationsgraden bis zu ca. 50 und dementsprechend spröde und schwer zu verarbeiten.

Der Erfindung liegt die Aufgabe zugrunde, hochmolekulare, nicht spröde Polymere mit guter Verarbeitbarkeit und hoher elektrischer Leitfähigkeit zu schaffen.

Diese Aufgabe wurde dadurch gelöst, dass als Katalysator für die Polymerisation eine oxidierend wirkende Lewis-Säure in Mengen von 1 bis 50, bevorzugt 10 bis 40 Gew.-%, bezogen auf das Gewicht der zu polymerisierenden Monomeren, verwendet wird.

Bevorzugte Lewis-Säuren sind $FeCl_3$, $FeBr_3$, $SbCl_5$, $SbF_5$, $AsF_5$, $CF_3-SO_3H$ oder eine Kombination von $AlCl_3$ bzw. $TiCl_4$ mit den genannten Verbindungen oder mit $CrO_3$ oder $OsO_4$.

Nach besonders bevorzugter Verfahrensweise lässt man gasförmiges $SbCl_5$, $SbF_5$ oder $AsF_5$ auf dünne Filme der zu polymerisierenden Monomeren, aufgebracht auf Glas oder Kunststoffolie, einwirken.

Die Polymerisationstemperatur wird im Bereich von − 80 bis + 100 °C, vorzugsweise von − 30 bis + 100 °C eingestellt. Das erfindungsgemässe Polymerisationsverfahren kann in üblichen Lösungsmitteln oder Hilfsflüssigkeiten, jedoch auch direkt in Substanz durchgeführt werden.

Die besonders bevorzugte Verfahrensvariante ist die oxidierende Polymerisation, bei der dünne Filme der oben genannten Monomeren auf Glas oder polymeren Trägern, vorzugsweise Folien − ein- oder beidseitig − mit gasförmigen Initiatoren wie $SbCl_5$, $SbF_5$ oder $AsF_5$ polymerisiert werden.

Die nach dem erfindungsgemässen Verfahren hergestellten Polymeren sind löslich und haben Intrinsic Viskositäten [$\eta$] 0,5, d.h. Molgewichte grösser als 25000 (entsprechend der Umrechnungsformel der in Literatur «Macromolecular Synthesis», Vol. I, [1974], Seite 83, Verlag John Wiley, New York). Die so hergestellten Polymeren haben elektrische Leitfähigkeitswerte von ca. $10^{-10}$ bis $10^{-3}$ S/cm, in Abhängigkeit von der Menge des im Polymeren verbliebenen Katalysators.

Durch Erhöhung der Menge des erfindungsgemässen Katalysators während oder nach der Polymerisation bis zu 50 Gew.-% gelingt es, elektrische Leitfähigkeiten bis zu $10^{+2}$ S/cm zu erreichen. Die Messung der elektrischen Leitfähigkeit erfolgt nach F. Beck, Ber. der Bensenges. 68, (1964), Seite 559.

Die erfindungsgemäss hergestellten elektrisch leitfähigen Polymeren mit elektrischen Leitfähigkeiten grösser als $10^{-2}$ S/cm sind zur antistatischen Ausrüstung von Kunststoffen, zum Herstellen von Sonnenzellen, zur Umwandlung und Fixierung von Strahlung sowie zur Herstellung elektrischer und magnetischer Schalter geeignet. Durch die Zusätze der starken Lewis-Säuren zu den Monomeren, bzw. Polymeren, entstehen sog. p-Leiter (vgl. J. Chem. Education, Vol. 46, [1969] (2), Seite 82).

Die in den folgenden Beispielen genannten Teile sind Gewichtsteile, bzw. Molprozente.

Beispiel 1

Eine Lösung von 10 Teilen Biphenyl wird in 100 Teilen Diäthyläther bei − 80 °C gelöst mit 10 Teilen Acetylen versetzt und bei dieser Temperatur mit 1 Teil Antimonpentafluorid versetzt. Nach der Zugabe wird die Lösung im Verlauf von 5 Stunden auf 25 °C erwärmt und das Lösungsmittel abgezogen. Das Polymerisat ist löslich in Benzol und hat ein Molgewicht von ca. 150 000. Die elektrische Leitfähigkeit dieses Produktes beträgt $2.5 \cdot 10^{-2}$.

Beispiel 2 bis 5

Wird wie im Beispiel 1 beschrieben gearbeitet, jedoch Menge und Art der Monomeren und des Initiators variiert, so werden die folgenden Ergebnisse erhalten.

| Nr. | Monomere und Menge (Teile) | Temp. °C | Initiator Art Teile | Leitfähigkeit S/cm 30 °C |
|---|---|---|---|---|
| 2 | 10 Biphenyl + 5 Phenylacetylen | 10 | $AsF_5$ 2 | $3,5 \cdot 10^{-1}$ |
| 3 | 10 Biphenyl + 5 Acetylen | −80 | $AsF_5$ 3 | $8,0 \cdot 10^{-1}$ |
| 4 | 10 Terphenyl + 10 Acetylen | −80 | $SbF_5$ 3 | $9,6 \cdot 10^{-1}$ |
| 5 | 10 Biphenyl + 10 Acetylen | −30 | $AlCl_3$ 2/ $CrO_3$ 0,5 | $4,5 \cdot 10^{-4}$ |

Beispiel 6

Es wird wie im Beispiel 1 beschrieben gearbeitet, jedoch das Monomere variiert, so werden die folgenden Ergebnisse erzielt.

| Nr. | Monomere und Menge (Teile) | Leitfähigkeit | S/cm 30 °C |
|---|---|---|---|
| 6 | 10 N-Vinylcarbazol + 10 $CH \equiv CH$ | 0,8 | $10^{-2}$ |
| 7 | 10 2-Vinylpyridin + 10 $CH \equiv CH$ | 3,9 | $10^{-2}$ |
| 8 | 10 4-Vinylpyridin + 10 $CH \equiv CH$ | 1,9 | $10^{-1}$ |

Beispiele 10 bis 15

| Nr. | Polymerisat nach Beispiel | Lewis-Säure Art und Menge | Leitfähigkeit S/cm 30 °C |
|---|---|---|---|
| 9 | 1 | 1 $AsF_5$ | $1,5 \cdot 10^{+1}$ |
| 10 | 1 | 3 $AsF_5$ | $3,0 \cdot 10^{+2}$ |
| 11 | 1 | 4 $AsF_5$ | $4,0 \cdot 10^{+1}$ |
| 12 | 1 | 5 $AsF_5$ | $4,1 \cdot 10^{+1}$ |
| 13 | 3 | 5 $AsF_5$ | $1,0 \cdot 10^{+2}$ |
| 14 | 4 | 5 $AsF_5$ | $2,6 \cdot 10^{+1}$ |

## Patentansprüche

1. Verfahren zur Herstellung von elektrisch leitfähigen Copolymeren durch Copolymerisation von

a) Acenaphthylen, Biphenyl, Terphenyl, Quarterphenyl oder von Oligophenylenen, oder N-Vinylcarbazol, 2- oder 4-Vinylpyridin oder von N,N-Divinylanilin und

b) Acetylen bei Temperaturen von $-80$ bis $+100\,°C$, dadurch gekennzeichnet, dass als Katalysator eine oxidierend wirkende Lewis-Säure in Mengen von 1 bis 50, bevorzugt 10 bis 40 Gew.-%, bezogen auf das Gewicht der zur polymerisierenden Monomeren, verwendet wird.

2. Verfahren nach Anspruch 1, dadurch gekennzeichnet, dass $FeCl_3$, $FeBr_3$, $SbCl_5$, $SbF_5$, $AsF_5$, $CF_3-SO_3H$ oder eine Kombination von $AlCl_3$ bzw. $TiCl_4$ mit den genannten Verbindungen oder mit $CrO_3$ oder $OsO_4$ verwendet wird.

3. Verfahren nach Ansprüchen 1 und 2, dadurch gekennzeichnet, dass gasförmiges $SbCl_5$, $SbF_5$ oder $AsF_5$ auf dünne Filme der zu polymerisierenden Monomeren, aufgebracht auf Glas oder polymeren Trägern, vorzugsweise Kunststoffolie, einwirkt.

4. Verwendung der nach Anspruch 1 hergestellten elektrisch leitfähigen Polymeren in der Elektrotechnik zur Herstellung von Sonnenzellen, zur Umwandlung und Fixierung von Strahlung und zur Herstellung elektrischer und magnetischer Schalter.

5. Verwendung der nach Anspruch 1 hergestellten elektrisch leitfähigen Polymeren zur antistatischen Ausrüstung von Kunststoffen.

## Revendications

1. Procédé pour la préparation de copolymères électriquement conducteurs par copolymérisation de

a) acénaphthylène, biphényle, terphényle, quaterphényle ou d'obligophénylènes, de N-vinyl carbazole, de 2- ou 4-vinylpyridine ou de N,N-divinylaniline et

b) d'acétylène à des températures de $-80$ à $+100\,°C$, caractérisé en ce qu'on utilise, comme catalyseur, un acide de Lewis à action oxydante dans des proportions de 1 à 50, de préférence 10 à 40% en poids par rapport au poids des monomères à polymériser.

2. Procédé selon la revendication 1, caractérisé en ce qu'on utilise $FeCl_3$, $FeBr_3$, $SbCl_5$, $SbF_5$, $CF_3-SO_3H$ ou une combinaison de $AlCl_3$ ou $TiCl_4$ avec les composés cités ou avec $CrO_3$ ou $OsO_4$.

3. Procédé selon la revendication 1 ou 2, caractérisé en ce qu'on fait agir $SbCl_5$, $SbF_5$ ou $AsF_5$ sur des pellicules minces des monomères à polymériser, appliquées sur du verre ou sur des supports de polymère, de préférence des feuilles minces de matière synthétique.

4. Utilisation de polymères électriquement conducteurs préparés suivant la revendication 1 dans l'électrotechnique pour la fabrication de piles solaires, pour la transformation et la fixation de rayonnement et pour la fabrication de commutateurs électriques et magnétiques.

5. Utilisation des polymères électriquement conducteurs préparés suivant la revendication 1 pour l'apprêt antistatique de matières synthétiques.

## Claims

1. A process for the production of electrically conductive copolymers by copolymerization of

(a) acenaphthylene, biphenyl, terphenyl, quaterphenyl, oligophenylenes, n-vinylcarbazole, 2-vinylpyridine, 4-vinylpyridine or N,N-divinylaniline, and

(b) acetylene at a temperature of from $-80$ to $+100\,°C$, wherein an oxidizing Lewis acid is used as catalyst in an amount of from 1 to 50%, preferably from 10 to 40%, by weight, based on the weight of the monomers to be polymerized.

2. A process as claimed in claim 1, wherein $FeCl_3$, $FeBr_3$, $SbCl_5$, $SbF_5$, $AsF_5$ or $CF_3$–$SO_3H$, or a combination of $AlCl_3$ or $TiCl_4$ with the said compounds or with $CrO_3$ or $OsO_4$ is used.

3. A process as claimed in claims 1 and 2, wherein gaseous $SbCl_4$, $SbF_5$ or $AsF_5$ acts on thin films of the monomers to be polymerized, applied to glass or polymeric supports, preferably plastics film.

4. The use of the electrically conductive polymers, prepared according to claim 1, in electrical engineering for the production of solar cells, for the conversion and fixation of radiation, and for the production of electrical and magnetic switches.

5. The use of the electrically conductive polymers, prepared according to claim 1, for the anti-static finishing of plastics.